# EUROPEAN PATENT APPLICATION

(11) **EP 4 729 241 A1**
(43) Date of publication of application: **22.04.2026**
(21) Application number: 25207774.8
(22) Date of filing: 09.10.2025
(51) Int. Cl.: B25F 5/00

(54) **POWER CONTROL MODULE WITH COMPACT THERMAL MANAGEMENT STRUCTURE**

(30) Priority: 09.10.2024 US 202463705143 P
(71) Applicant: Black & Decker, Inc., New Britain, CT 06053 (US)
(72) Inventor: SIRAGUSA, Matthew A., Towson, 21286 (US); FRIEDMAN, Brian E., Towson, 21286 (US); WACHTER, Eric W., Towson, 21286 (US)
(74) Representative: Slingsby Partners LLP

(57) **Abstract**

A power control module may include a circuit board; a plurality of power switch devices including a plurality of high-side power switches and a plurality of low-side power switches mounted on the circuit board and configured as a multi-phase inverter circuit to provide a plurality of output phase terminals to the electric motor, each power switch device including a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit.

## Description

### BACKGROUND

### 1. Technical Field

This disclosure relates generally to an electronic power control module and, in some non-limiting embodiments or aspects, to an electronic power control module with a compact thermal management structure.

### 2. Technical Considerations

As expectations increase for larger current carrying loads in smaller volumetric spaces to facilitate ergonomic power tools and other electrically powered machine designs, alternate solutions need to be identified to reduce an overall size of electronic/electrical systems. One of the largest burdens on a Printed Circuit Board (PCB) geometrical area is the need to attach wires which connect to battery terminals, motor phase terminals, and/or the terminals of other current carrying devices and machines. This is typically accomplished with metallic plated holes drilled through the PCB, which allow solderability of the wire to the board. Keep out regions, or areas free of electronic components or connectors, accompany these plated through holes to facilitate manufacturability and to reduce or prevent defects from occurring, such as short circuits, broken, damaged, or missing components, and/or the like during an attachment process. Often these wires are soldered via hand soldering, wave soldering, robotic soldering, reflow soldering or welding.

Not only do these large plated through holes in the PCB take up usable geometric area that could be used for additional components and circuitry, but they also reduce area that can be used for additional thermal mass (e.g., heatsinking, heat spreading, copper foil layers in PCB, etc.), which are sued to keep semiconductor devices cool and from exceeding temperature ratings during periods of operation.

It is possible to solder the wires directly to the PCB, but this technique also uses keep out regions on the PCB, which expands an overall size of the electronic system and/or diminishes usable space on the PCB. It is a known practice to solder motor phase wires onto an opposite side of a PCB which holds a power electronic inverter. However, PCBs are thermally inefficient due to insulation layers used to separate metallic layers and, thus, the PCB provides a high thermal impedance in terms of the overall thermal network associated with a power electronic system. This leads to an increase in thermal rise for a given amount of power dissipation, where power dissipation is an exponential function of resistance and current.

In addition to PCB real estate that is typically used by wire termination, heatsinking and/or thermally conductive material, such as copper, aluminum, or the like with an inherent heat capacity and thermal resistance, tends to be a large consumer of geometrical space. Often, heatsinking is either soldered directly to the PCB, thus growing the overall size of a power electronic converter section, or mechanically pressed onto the component package with the use of Thermal Interface Material (TIM), or a material that is used to enhance thermal coupling between two materials. To achieve better thermal transfer for the latter solution, a constant mechanical pressure, or force, is applied to the TIM and power electronic hardware, which typically adds cost, size and complexity to an electronic system and manufacturing process. Additionally, to achieve better thermal transfer through a thermal interface material, more pressure than the electronic component or electrical system can physically handle may be required. Thus, it is difficult to fully utilize the heatsink thermal properties which often leads designers to sacrifice performance, cost, and/or physical size.

Additionally, power density is facilitated by an accurate understanding of critical component temperatures, which ensures reliability and an ability to utilize a full capability of semiconductor components without exceeding their respective temperature rating. Traditionally a thermistor may be placed near a hottest component and be utilized to sense temperature. However, this implementation has a slow response to transient temperature change and can only be used to monitor temperature in the surrounding area, which does not give a more accurate representation of true semiconductor junction temperature.

### SUMMARY

According to some non-limiting embodiments or aspects, provided is a control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the second surfaces including the metal surfaces of the plurality of power switch devices are oriented along a first plane, wherein lower portions of the plurality of power output terminals that electrically contact the metal surfaces of the plurality of power switch devices are oriented along a second plane parallel to the first plane, and wherein at least one of (i) each power output terminal is located substantially above a corresponding power switch, (ii) each power output terminal is oriented along a plane that is perpendicular to the second plane, or any combination thereof.

According to some non-limiting embodiments or aspects, provided is a control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the circuit board is oriented along a first plane, wherein lower portions of the plurality of the plurality of power output terminals that electrically contact the metal surfaces of the plurality of power switch devices are oriented along a second plane, wherein at least one of (i) each power output terminal is located substantially above a corresponding power switch, (ii) each power output terminal is oriented along a plane that is perpendicular to the first plane, or any combination thereof, and wherein the second surfaces including the metal surfaces of the plurality of power switch devices are oriented along a third plane parallel to the first plane and the second plane.

According to some non-limiting embodiments or aspects, provided is a control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the circuit board is oriented along a first plane, wherein lower portions of the plurality of the plurality of power output terminals that electrically contact the metal surfaces of the plurality of power switch devices are oriented along a second plane, wherein at least one of (i) each power output terminal is located substantially above a corresponding power switch, (ii) each power output terminal is oriented along a plane that is perpendicular to the first plane, or any combination thereof, and wherein the second surfaces including the metal surfaces of the plurality of power switch devices are oriented between the first plane and the second plane.

According to some non-limiting embodiments or aspects, provided is a control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the plurality of power switch devices defines a boundary area on the circuit board that includes the plurality of power switch devices and a spacing between the plurality of power switch devices, wherein the control module is configured to sustain a continuous current output of approximately 14 to 30 amps at a nominal voltage level of approximately between 8 to 20 volts, wherein the plurality of power output terminals is contained within the boundary area, wherein a first cumulative area within the boundary area that is defined by the plurality of power switch devices themselves is greater than a second cumulative area within the boundary area that is defined by the spacing between the plurality of power switch devices, and wherein the first cumulative area includes at least 76% of the boundary area.

According to some non-limiting embodiments or aspects, provided is a control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the plurality of power switch devices defines a boundary area on the circuit board that includes the plurality of power switch devices and a spacing between the plurality of power switch devices, wherein the control module is configured to sustain a continuous current output of approximately 14 to 30 amps at a nominal voltage level of approximately between 8 to 20 volts, wherein the plurality of power output terminals is contained within the boundary area, and wherein a first cumulative area within the boundary area that is defined by the plurality of power switch devices themselves is greater than a second cumulative area within the boundary area that is defined by the spacing between the plurality of power switch devices, and wherein the second cumulative area is between approximately 12% to 24% of the boundary area.

According to some non-limiting embodiments or aspects, provided is a control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the circuit board is free of through holes configured to secure the plurality of power output terminals to the circuit board.

According to some non-limiting embodiments or aspects, provided is a control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein an area of the circuit board proximate the plurality of power switches does not include through holes configured to secure the plurality of power output terminals to the circuit board.

According to some non-limiting embodiments or aspects, provided is a control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein a greater portion of a static strength of a connection of the plurality of power output terminals to the circuit board is provided via first portions of the plurality of power output terminals mounted discretely on the plurality of low-side power switches than remaining portions of the plurality of power output terminals not mounted discretely on the plurality of low-side power switches.

In some non-limiting embodiments or aspects, the control module further comprises: a heatsink having an elongate body extending along an axis mounted on the second surface of the plurality of high-side power switches, wherein the heatsink is electrically coupled to the metal surface of the plurality of high-side power switches.

In some non-limiting embodiments or aspects, the plurality of power output terminals is not in physical contact with the circuit board.

In some non-limiting embodiments or aspects, the plurality of power output terminals does not have a direct electric contact with any node of the plurality of power switch devices through the circuit board.

In some non-limiting embodiments or aspects, the plurality of power output terminals extends from the metal surfaces of the plurality of power switch devices including the low-side power switches along a plane that is perpendicular to the circuit board.

In some non-limiting embodiments or aspects, the plane intersects the plurality of low-side power switches.

In some non-limiting embodiments or aspects, the control module further comprises: a heatsink having an elongate body extending along an axis mounted on the second surface of the plurality of high-side power switches, wherein the axis of the elongate body of the heatsink is parallel to the plane.

In some non-limiting embodiments or aspects, at least one power switch device of the plurality of power switch devices includes at least one high-side power switch of the plurality of high-side power switches and at least one low-side power switch of the plurality of low-side power switches connected in series in a half-bridge configuration.

In some non-limiting embodiments or aspects, at least one power switch device of the plurality of power switch devices includes at least two high-side power switches of the plurality of high-side power switches connected in parallel or at least two low-side power switches of the plurality of low-side power switches connected in parallel.

In some non-limiting embodiments or aspects, the control module further includes: an insulating frame extending between at least one pair of power output terminals of the plurality of power output terminals.

In some non-limiting embodiments or aspects, the insulating frame is molded on the plurality of power output terminals.

In some non-limiting embodiments or aspects, the control module further comprises: at least one shunt component mounted on the circuit board and electrically coupled in series with at least one low-side power switch of the plurality of low-side power switches and a node of the DC power source.

In some non-limiting embodiments or aspects, the control module further comprises: a microcontroller mounted on the circuit board, wherein the microcontroller is configured to: monitor a current passing through the at least one shunt component; and control, based on the current passing through the at least one shunt component, a field-oriented communication of the electric motor powered by the control module.

In some non-limiting embodiments or aspects, the control module further comprises: an auxiliary circuit board that extends substantially perpendicularly from the circuit board, wherein the auxiliary circuit board includes a pair of metallic plated holes configured to receive a corresponding pair of power input wires electrically coupled to corresponding nodes of the DC power source.

In some non-limiting embodiments or aspects, the control module further comprises: at least one capacitor mounted on the auxiliary circuit board and extending substantially parallel to main circuit board.

In some non-limiting embodiments or aspects, the plurality of power switch devices includes a first row of power switch devices including the plurality of high-side power switches and a second row of power switches mounted parallel to the first row on the circuit board and including the plurality of low-side switches.

In some non-limiting embodiments or aspects, the plurality of power output terminals extends from a plurality of first ends mounted discretely on the plurality of low-side power switches and electrically contacting the metal surface of the plurality of low-side power switches to a plurality of second ends including a plurality of power output holes configured to receive a plurality of power output wires, wherein the plurality of second ends including the plurality of power output holes is oriented substantially perpendicular to the circuit board.

In some non-limiting embodiments or aspects, the plurality of power output terminals includes a plurality of first portions including the plurality of first ends mounted discretely on the plurality of low-side power switches and electrically contacting the metal surface of the plurality of low-side power switches, a plurality of second portions extending perpendicularly from the plurality of first portions, a plurality of third portions extending perpendicularly from the plurality of second portions, and a plurality of fourth portions including the plurality of second ends including the plurality of power output holes extending perpendicularly from the plurality of third portions.

In some non-limiting embodiments or aspects, the control module further comprises: an insulating frame including: a base portion extending between (i) the plurality of first portions of the plurality of power output terminals and (ii) the and the plurality of third portions of the plurality of power output terminals; at least one upper partition wall extending from the base portion in a direction away from the circuit board between at least one pair of power output terminals of the plurality of power output terminals; at least one sidewall extending from at least one end of the base portion toward the circuit board; and at least one lower partition wall extending from the base portion in a direction toward the circuit board between at least one pair of low-side power switches of the plurality of low-side power switches.

In some non-limiting embodiments or aspects, the plurality of power output terminals extends from a plurality of first ends mounted discretely on the plurality of low-side power switches and electrically contacting the metal surface of the plurality of low-side power switches to a plurality of second ends including a plurality of power output holes configured to receive a plurality of fasteners electrically coupled to a plurality of ring terminals electrically coupled to a plurality of power output wires, wherein the plurality of second ends including the plurality of power output holes is oriented substantially parallel to the circuit board.

In some non-limiting embodiments or aspects, the plurality of power output terminals includes a plurality of first portions including the plurality of first ends mounted discretely on the plurality of low-side power switches and electrically contacting the metal surface of the plurality of low-side power switches, a plurality of second portions extending perpendicularly from the plurality of first portions, and a plurality of third portions including the plurality of second ends including the plurality of power output holes extending perpendicularly from the plurality of second portions over the plurality of first portions including the plurality of first ends mounted discretely on the plurality of low-side power switches.

In some non-limiting embodiments or aspects, the control module further comprises: an insulating frame including: a base portion extending between the plurality of first portions of the plurality of power output terminals and the and the plurality of third portions of the plurality of power output terminals; at least one upper partition wall extending from the base portion in a direction away from the circuit board between at least one pair of power output terminals of the plurality of power output terminals and proximate the second end of at least on power output terminal of the at least one pair of power output terminals; at least one sidewall extending from at least one end of the base portion toward the circuit board; and at least one lower partition wall extending from the base portion in a direction toward the circuit board between at least one pair of low-side power switches of the plurality of low-side power switches.

According to some non-limiting embodiments or aspects, provided is an electric power tool including: a tool housing; an electric motor disposed in the tool housing; and the control module disposed in the tool housing.

According to some non-limiting embodiments or aspects, provided is a system including: a DC power source; a power consuming component; and the control configured to control a supply of electric power from the DC power source to the power consuming component.

In some non-limiting embodiments or aspects, the DC power source includes at least one battery.

In some non-limiting embodiments or aspects, the power consuming component includes an electric motor.

Further non-limiting embodiments or aspects are set forth in the following numbered clauses:
Clause 1: A control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the second surfaces including the metal surfaces of the plurality of power switch devices are oriented along a first plane, wherein lower portions of the plurality of power output terminals that electrically contact the metal surfaces of the plurality of power switch devices are oriented along a second plane parallel to the first plane, and wherein at least one of (i) each power output terminal is located substantially above a corresponding power switch, (ii) each power output terminal is oriented along a plane that is perpendicular to the second plane, or any combination thereof.
Clause 2: A control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the circuit board is oriented along a first plane, wherein lower portions of the plurality of the plurality of power output terminals that electrically contact the metal surfaces of the plurality of power switch devices are oriented along a second plane, wherein at least one of (i) each power output terminal is located substantially above a corresponding power switch, (ii) each power output terminal is oriented along a plane that is perpendicular to the first plane, or any combination thereof, and wherein the second surfaces including the metal surfaces of the plurality of power switch devices are oriented along a third plane parallel to the first plane and the second plane.
Clause 3: A control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the circuit board is oriented along a first plane, wherein lower portions of the plurality of the plurality of power output terminals that electrically contact the metal surfaces of the plurality of power switch devices are oriented along a second plane, wherein at least one of (i) each power output terminal is located substantially above a corresponding power switch, (ii) each power output terminal is oriented along a plane that is perpendicular to the first plane, or any combination thereof, and wherein the second surfaces including the metal surfaces of the plurality of power switch devices are oriented between the first plane and the second plane.
Clause 4: A control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the plurality of power switch devices defines a boundary area on the circuit board that includes the plurality of power switch devices and a spacing between the plurality of power switch devices, wherein the control module is configured to sustain a continuous current output of approximately 14 to 30 amps at a nominal voltage level of approximately between 8 to 20 volts, wherein the plurality of power output terminals is contained within the boundary area, wherein a first cumulative area within the boundary area that is defined by the plurality of power switch devices themselves is greater than a second cumulative area within the boundary area that is defined by the spacing between the plurality of power switch devices, and wherein the first cumulative area includes at least 76% of the boundary area.
Clause 5: A control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the plurality of power switch devices defines a boundary area on the circuit board that includes the plurality of power switch devices and a spacing between the plurality of power switch devices, wherein the control module is configured to sustain a continuous current output of approximately 14 to 30 amps at a nominal voltage level of approximately between 8 to 20 volts, wherein the plurality of power output terminals is contained within the boundary area, and wherein a first cumulative area within the boundary area that is defined by the plurality of power switch devices themselves is greater than a second cumulative area within the boundary area that is defined by the spacing between the plurality of power switch devices, and wherein the second cumulative area is between approximately 12% to 24% of the boundary area.
Clause 6: A control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein the circuit board is free of through holes configured to secure the plurality of power output terminals to the circuit board.
Clause 7: A control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein an area of the circuit board proximate the plurality of power switches does not include through holes configured to secure the plurality of power output terminals to the circuit board.
Clause 8: A control module for supplying electric power from a DC power source to an electric motor, comprising: a circuit board; a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and a plurality of power output terminals mounted discretely on the plurality of low-side power switches and electrically contacting the metal surface of the plurality of low-side power switches to be electrically coupled to the plurality of output phase terminals of the inverter circuit, wherein a greater portion of a static strength of a connection of the plurality of power output terminals to the circuit board is provided via first portions of the plurality of power output terminals mounted discretely on the plurality of low-side power switches than remaining portions of the plurality of power output terminals not mounted discretely on the plurality of low-side power switches.
Clause 9: The control module of any of clauses 1-8, further comprising: a heatsink having an elongate body extending along an axis mounted on the second surface of the plurality of high-side power switches, wherein the heatsink is electrically coupled to the metal surface of the plurality of high-side power switches.
Clause 10: The control module of any of clauses 1-9, wherein the plurality of power output terminals is not in physical contact with the circuit board.
Clause 11: The control module of any of clauses 1-10, wherein the plurality of power output terminals does not have a direct electric contact with any node of the plurality of power switch devices through the circuit board.
Clause 12: The control module of any of clauses 1-11, wherein the plurality of power output terminals extends from the metal surfaces of the plurality of power switch devices including the low-side power switches along a plane that is perpendicular to the circuit board.
Clause 13: The control module of any of clauses 1-12, wherein the plane intersects the plurality of low-side power switches.
Clause 14: The control module of any of clauses 1-13, further comprising: a heatsink having an elongate body extending along an axis mounted on the second surface of the plurality of high-side power switches, wherein the axis of the elongate body of the heatsink is parallel to the plane.
Clause 15: The control module of any of clauses 1-14, wherein at least one power switch device of the plurality of power switch devices includes at least one high-side power switch of the plurality of high-side power switches and at least one low-side power switch of the plurality of low-side power switches connected in series in a half-bridge configuration.
Clause 16: The control module of any of any of clauses 1-15, wherein at least one power switch device of the plurality of power switch devices includes at least two high-side power switches of the plurality of high-side power switches connected in parallel or at least two low-side power switches of the plurality of low-side power switches connected in parallel.
Clause 17. The control module of any of any of clauses 1-16, further comprising: an insulating frame extending between at least one pair of power output terminals of the plurality of power output terminals.
Clause 18: The control module of any of clauses 1-17, wherein the insulating frame is molded on the plurality of power output terminals.
Clause 19: The control module of any of clauses 1-18, further comprising: at least one shunt component mounted on the circuit board and electrically coupled in series with at least one low-side power switch of the plurality of low-side power switches and a node of the DC power source.
Clause 20: The control module of any of clauses 1-19, further comprising: a microcontroller mounted on the circuit board, wherein the microcontroller is configured to: monitor a current passing through the at least one shunt component; and control, based on the current passing through the at least one shunt component, a field-oriented communication of the electric motor powered by the control module.
Clause 21: The control module of any of clauses 1-20, further comprising: an auxiliary circuit board that extends substantially perpendicularly from the circuit board, wherein the auxiliary circuit board includes a pair of metallic plated holes configured to receive a corresponding pair of power input wires electrically coupled to corresponding nodes of the DC power source.
Clause 22: The control module of any of clauses 1-21, further comprising: at least one capacitor mounted on the auxiliary circuit board and extending substantially parallel to main circuit board.
Clause 23: The control module of any of clauses 1-22, wherein the plurality of power switch devices includes a first row of power switch devices including the plurality of high-side power switches and a second row of power switches mounted parallel to the first row on the circuit board and including the plurality of low-side switches.
Clause 24: The control module of any of clauses 1-23, wherein the plurality of power output terminals extends from a plurality of first ends mounted discretely on the plurality of low-side power switches and electrically contacting the metal surface of the plurality of low-side power switches to a plurality of second ends including a plurality of power output holes configured to receive a plurality of power output wires, wherein the plurality of second ends including the plurality of power output holes is oriented substantially perpendicular to the circuit board.
Clause 25: The control module of any of clauses 1-24, wherein the plurality of power output terminals includes a plurality of first portions including the plurality of first ends mounted discretely on the plurality of low-side power switches and electrically contacting the metal surface of the plurality of low-side power switches, a plurality of second portions extending perpendicularly from the plurality of first portions, a plurality of third portions extending perpendicularly from the plurality of second portions, and a plurality of fourth portions including the plurality of second ends including the plurality of power output holes extending perpendicularly from the plurality of third portions.
Clause 26: The control module of any of clauses 1-25, further comprising: an insulating frame including: a base portion extending between (i) the plurality of first portions of the plurality of power output terminals and (ii) the and the plurality of third portions of the plurality of power output terminals; at least one upper partition wall extending from the base portion in a direction away from the circuit board between at least one pair of power output terminals of the plurality of power output terminals; at least one sidewall extending from at least one end of the base portion toward the circuit board; and at least one lower partition wall extending from the base portion in a direction toward the circuit board between at least one pair of low-side power switches of the plurality of low-side power switches.
Clause 27: The control module of any of any of clauses 1-26, wherein the plurality of power output terminals extends from a plurality of first ends mounted discretely on the plurality of low-side power switches and electrically contacting the metal surface of the plurality of low-side power switches to a plurality of second ends including a plurality of power output holes configured to receive a plurality of fasteners electrically coupled to a plurality of ring terminals electrically coupled to a plurality of power output wires, wherein the plurality of second ends including the plurality of power output holes is oriented substantially parallel to the circuit board.
Clause 28: The control module of any of clauses 1-27, wherein the plurality of power output terminals includes a plurality of first portions including the plurality of first ends mounted discretely on the plurality of low-side power switches and electrically contacting the metal surface of the plurality of low-side power switches, a plurality of second portions extending perpendicularly from the plurality of first portions, and a plurality of third portions including the plurality of second ends including the plurality of power output holes extending perpendicularly from the plurality of second portions over the plurality of first portions including the plurality of first ends mounted discretely on the plurality of low-side power switches.
Clause 29: The control module of any of clauses 1-28, further comprising: an insulating frame including: a base portion extending between the plurality of first portions of the plurality of power output terminals and the and the plurality of third portions of the plurality of power output terminals; at least one upper partition wall extending from the base portion in a direction away from the circuit board between at least one pair of power output terminals of the plurality of power output terminals and proximate the second end of at least on power output terminal of the at least one pair of power output terminals; at least one sidewall extending from at least one end of the base portion toward the circuit board; and at least one lower partition wall extending from the base portion in a direction toward the circuit board between at least one pair of low-side power switches of the plurality of low-side power switches.
Clause 30: An electric power tool comprising: a tool housing; an electric motor disposed in the tool housing; and the control module of any of clauses 1-29 disposed in the tool housing.
Clause 31: A system comprising: a DC power source; a power consuming component; and the control module of any of clauses 1-29 configured to control a supply of electric power from the DC power source to the power consuming component.
Clause 32: The system of clause 31, wherein the DC power source includes at least one battery.
Clause 33: The system of clause 31 or 32, wherein the power consuming component includes an electric motor.

These and other features and characteristics of the present disclosure, as well as the methods of operation and functions of the related elements of structures and the combination of parts and economies of manufacture, will become more apparent upon consideration of the following description and the appended claims with reference to the accompanying drawings, all of which form a part of this specification, wherein like reference numerals designate corresponding parts in the various figures. It is to be expressly understood, however, that the drawings are for the purpose of illustration and description only and are not intended as a definition of the limits of the disclosed subject matter.

### BRIEF DESCRIPTION OF THE DRAWINGS

Additional advantages and details are explained in greater detail below with reference to the non-limiting, exemplary embodiments that are illustrated in the accompanying schematic figures, in which:
FIG. 1 depicts a side view of a power tool with a housing half removed, according to some non-limiting embodiments or aspects;
FIG. 2 depicts a block circuit diagram of a control module mounted in connection with a stator assembly of a corresponding electric motor, according to some non-limiting embodiments or aspects;
FIG. 3 depicts a circuit diagram of a power switch circuit of a control module, according to some non-limiting embodiments or aspects;
FIGS. 4A depicts a partially exploded perspective view of a control module, according to some non-limiting embodiments or aspects;
FIG. 4B depicts a perspective view of a control module, according to some non-limiting embodiments or aspects;
FIG. 4C depicts a side perspective view of a control module, according to some non-limiting embodiments or aspects;
FIG. 5A depicts a partially exploded perspective view of a control module including an insulating frame, according to some non-limiting embodiments or aspects;
FIG. 5B depicts a perspective view of a control module including an insulating frame, according to some non-limiting embodiments or aspects;
FIG. 5C depicts a side perspective view of a control module including an insulating frame, according to some non-limiting embodiments or aspects;
FIG. 6A depicts a side view a control module, according to some non-limiting embodiments or aspects;
FIG. 6B depicts a cross sectional view of a control module, according to some non-limiting embodiments or aspects;
FIG. 7A depicts a perspective view of a control module with power output wires and power input wires respectively connected to power output terminals and power input terminals of the control module, according to some non-limiting embodiments or aspects;
FIG. 7B depicts a side perspective view of a control module with power output wires and power input wires respectively connected to power output terminals and power input terminals of the control module, according to some non-limiting embodiments or aspects;
FIG. 8A depicts a perspective view of a control module with power output terminals configured for ring terminals connections, according to some non-limiting embodiments or aspects;
FIG. 8B depicts a top perspective view of a control module with power output terminals configured for ring terminals connections, according to some non-limiting embodiments or aspects;
FIG. 8C depicts a perspective view of a control module with power output terminals with ring terminal connections connecting power output wires to the power output terminals, according to some non-limiting embodiments or aspects;
FIGS. 9A and 9B are top and bottom perspective views of a power switch device that includes a single power switch; and
FIGS. 10A and 10B are top and bottom perspective view of a power switch device that includes multiple power switches.

### DETAILED DESCRIPTION

For purposes of the description hereinafter, the terms "end," "upper," "lower," "right," "left," "vertical," "horizontal," "top," "bottom," "lateral," "longitudinal," and derivatives thereof shall relate to the embodiments as they are oriented in the drawing figures. However, it is to be understood that the embodiments may assume various alternative variations and step sequences, except where expressly specified to the contrary. It is also to be understood that the specific devices and processes illustrated in the attached drawings, and described in the following specification, are simply exemplary embodiments or aspects of the disclosed subject matter. Hence, specific dimensions and other physical characteristics related to the embodiments or aspects disclosed herein are not to be considered as limiting.

It is to be understood that the present disclosure may assume various alternative variations and step sequences, except where expressly specified to the contrary. It is also to be understood that the specific devices and processes illustrated in the attached drawings, and described in the following specification, are simply exemplary and non-limiting embodiments or aspects. Hence, specific dimensions and other physical characteristics related to the embodiments or aspects disclosed herein are not to be considered as limiting.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one." Furthermore, as used herein, the term "set" is intended to include one or more items (e.g., related items, unrelated items, a combination of related and unrelated items, and/or the like) and may be used interchangeably with "one or more" or "at least one." Where only one item is intended, the term "one" or similar language is used. Also, as used herein, the terms "has," "have," "having," or the like are intended to be open-ended terms. Further, the phrase "based on" is intended to mean "based at least partially on" unless explicitly stated otherwise. In addition, reference to an action being "based on" a condition may refer to the action being "in response to" the condition. For example, the phrases "based on" and "in response to" may, in some non-limiting embodiments or aspects, refer to a condition for automatically triggering an action (e.g., a specific operation of an electronic device, such as a computing device, a processor, and/or the like).

Some of the techniques described herein may be implemented by one or more computer programs executed by one or more processors residing, for example on a power tool or power equipment. The computer programs may include processor-executable instructions that are stored on a non-transitory tangible computer readable medium. The computer programs may also include stored data. Non-limiting examples of the non-transitory tangible computer readable medium are nonvolatile memory, magnetic storage, and optical storage.

Advances in semiconductor packaging have enabled an increase in power density due to decreases in device/package thermal impedance, often denoted at R_{J-C} or Junction to Case Thermal Impedance. One way that this is accomplished is by exposing a designated terminal of the semiconductor device through a top side of the component package (e.g., the Drain or Source of a three terminal Metal Oxide Semiconductor Field Effect Transistor (MOSFET), etc.). These devices may include a single transistor, or a plurality of transistors, co-packaged together. A transistor may include a MOSFET, a Bipolar Junction Transistor (BJT), a Silicon Carbide Field Effect Transistor (SiCFET), a Gallium Nitride Field Effect Transistor (GaNFET), a Gallium Nitride High Electron Mobility Transistor (GaN HEMT), an Insulated Gate Bipolar Transistor (IGBT), and/or other current-controlled or voltage-controlled semiconductor switches. The transistors may be arranged within the package or device in a variety of configurations such as in a single half bridge (e.g., in which two transistors which share a common electrical node -the High Side FET source and the Low Side FET drain). This shared node of a half bridge may often be referred to as the switch node, or phase node - which is a point of electrical and mechanical connection for a traditional wire or phase termination in a motor drive), any number of half bridges (e.g., a Full Bridge, a three-phase inverter, etc.) or any configuration of multiple transistors (e.g., Common Source, Paralleled, etc.).

This reduced thermal impedance of exposed semiconductor package may be utilized by attaching a heatsink or heat spreader which uses of some type of Thermal Interface Material (TIM), such as thermal grease, a SIL PAD^{®}, or some type of thermally conductive and electrically isolating material. Although this technique allows for better thermal performance, it not only adds system cost but also provides its own addition of thermal impedance to the thermal network which does not utilize the full capability of the power electronic converter or heatsink for a given size and power requirement.

By utilizing the low thermal impedance associated with solder and/or sinter materials, such as combinations of Tin, Copper, Lead, Silver and/or others, and the advances in semiconductor packaging, which offers a low RJ-C, the direct soldering of heatsinks, phase terminations and/or wires to the exposed semiconductor package enables an increase in system power density by reducing thermal impedance and negating the inherent space constraining elements of traditional wire or heatsink attachment, thereby enabling less heat generation for a given amount of power in a geometric space. Additionally, a thermocouple, temperature sensor, or some type of temperature sensing element can be soldered, glued, taped, or otherwise attached to the exposed semiconductor package to give the system controller a more accurate representation of the true junction temperature of the device. For example, these advantages may be provided by direct attachment (e.g., soldered attachment, etc.) of a heatsink to exposed semiconductor package (e.g., the heatsink may be soldered only to the exposed semiconductor package or to a combination of exposed the semiconductor package and the surrounding Printed Circuit Board (PCB) area). As an example, these advantages may be provided by direct attachment (e.g., soldered attachment, etc.) of battery and/or motor phase wires directly to top of exposed semiconductor package. As another example, these advantages may be provided by direct attachment of battery and/or motor phase wires to thermally conductive termination directly soldered to the exposed semiconductor package, and/or a piece of thermal mass, such as a heatsink, and/or the like may also attach a wire through welding, soldering, a ring terminal, a nut and bolt, or some type of other mechanical connector. As a further example, these advantages may be provided by integration of a plurality of phase terminations and/or heatsinks, direct soldered to the exposed semiconductor package, in a single overmolded or insert-mold piece which can include the phase wires or include terminations to attach the phase wires. As a still further example, these advantages may be provided by direct attachment of a thermocouple, or temperature sensing element, to the exposed semiconductor package via soldering, glue, tape, or other form of attachment/adhesion, and the thermocouple may be electrically connected to the exposed semiconductor metal surface or electrically isolated using other means.

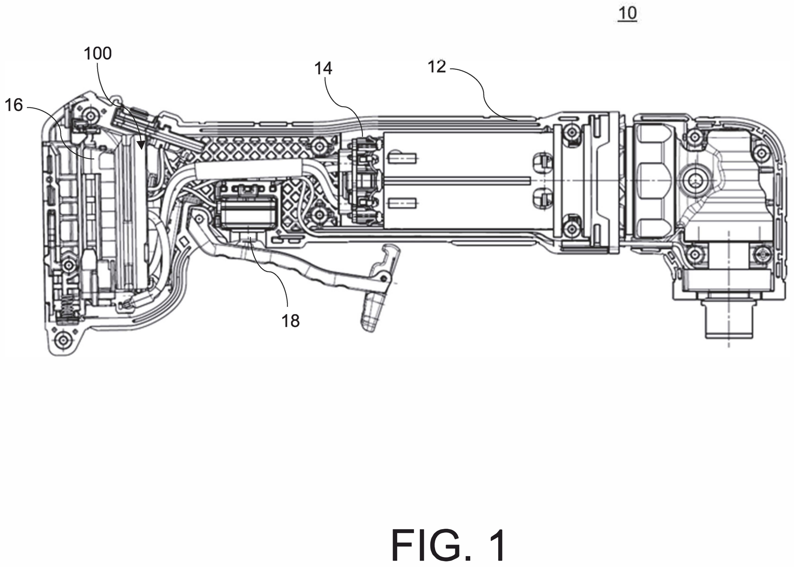

FIG. 1 depicts a side view of power tool 10 (e.g., a die grinder, etc.) with tool housing 12 half removed, according to some non-limiting embodiments or aspects. As shown in FIG. 1, power tool 10 may include tool housing 12, electric motor 14 (e.g., a high-power electric motor, etc.) disposed in tool housing 12, and/or control module 100 disposed in tool housing 12. Electric motor 14 may include a brushed DC motor, a brushless DC motor, such as an electric brushless direct-current (BLDC) drive motor, and/or the like.

Control module 100 may include a microcontroller, a microprocessor, or other programmable semiconductor chip and power switching components for controlling a commutation of electric motor 14. Alternatively, control module 100 may include an Application Specific Integrated Circuit (ASIC) and the power switching components. Control module 100 may be coupled to power source 16, which may include a DC power source (e.g., a removable battery pack, etc.) or an AC power source (e.g., a 120V AC, etc.). Control module 100 may control or regulate a supply of electric power from power source 16 to electric motor 14, for example, based on a logic signal from an input unit (e.g., trigger mechanism 18, etc.) electrically coupled to control module 100.

Some non-limiting embodiments or aspects of the present disclosure are focused on the structure and features of control module 100. Details of the components and operation of an exemplary power tool such as a grinder, including a brushless direct-current motor utilized therein, may be found in United States Patent Application Publication No. 2022/0247257 and United States Patent Application Publication No. 2017/0110945, which are incorporated herein by reference in their entireties.

It is noted herein that while some non-limiting embodiments or aspects of the present disclosure are described with reference to an angled die grinder, control module 100 and associated components discussed herein can be used with any system for controlling a supply of electric power from a power source 16 to a power consuming component, such as any brushless motor control application, and particularly in any power tool or motorized product application. For example, control module 100 may be used with a brushless motor in a drill, impact driver, grinder, saw, sander, tapper, nailer, powered cart and wheel barrow, lawn mower, lawn and garden tractor, lawn trimmer, lawn edger, lawn and leaf blower or sweeper, hedge trimmer, pruner, lopper, chainsaw, rake, pole saw, tiller, cultivator, aerator, log splitter, post hole digger, trencher, stump grinder, snow thrower (or any other snow or ice cleaning or clearing implement), lawn, wood and leaf shredder and chipper, lawn and/or leaf vacuum, pressure washer, lawn equipment, garden equipment, driveway sprayer and spreader, sports field marking equipment, or any other power tool or power consuming equipment.

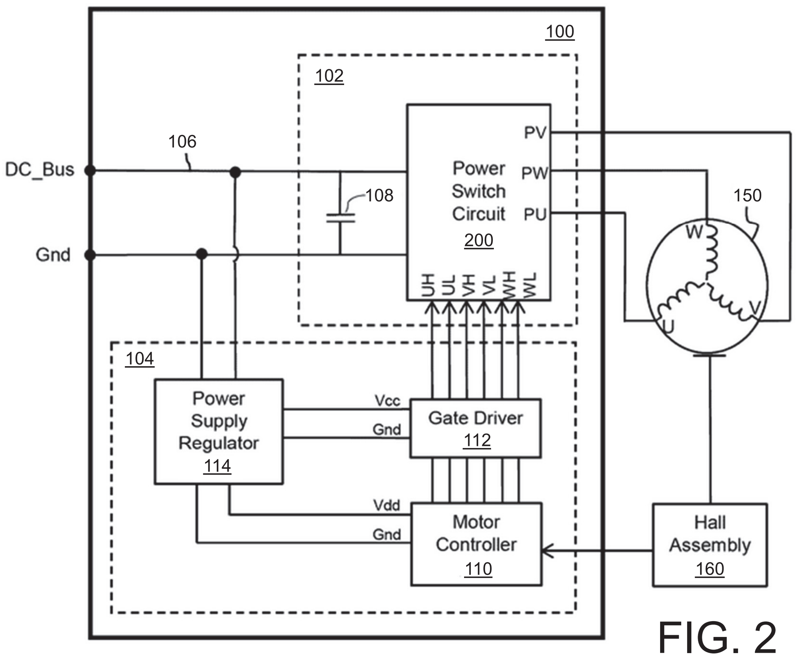

FIG. 2 depicts a block circuit diagram of control module 100 mounted in connection with stator assembly 150 of electric motor 14, according to some non-limiting embodiments or aspects. Control module 100 may include power unit 102 and/or control unit 104.

Power unit 102 may include power switch circuit 200 coupled between DC bus line 106 and stator assembly 150 to drive electric motor 14. In some implementations, power switch circuit 200 may include a three-phase inverter bridge driver circuit including controllable semiconductor power switches (e.g. FETs, BJTs, IGBTs, GaN FETs, GAN HEMTs, etc.). In some implementations, power unit 102 may include DC bus capacitor 108 provided across DC bus line 106 and Gnd.

Control unit 104 may include motor controller 110, gate driver 112, and/or power supply regulator 114. Motor controller 110 may include a programmable device arranged to control a switching operation of power switches in power switch circuit 200. In some implementations, motor controller 110 may receive rotor rotational position signals from Hall assembly 160 or other types of positional sensors that interact with a rotor. It should also be noted, however, that motor controller 110 may be configured to calculate or detect rotational positional information relating to the motor rotor using a sensorless control technique, such as field-oriented control. In some implementations, motor controller 110 may receive a variable-speed signal that relates to a desired speed of electric motor 14 (e.g., a desired speed set by an operator, etc.). Based on the rotor rotational position signals from Hall assembly 160 or the other types of positional sensors and the variable-speed signal, motor controller 110 may control a pulse-width modulation (PWM) control of drive signals UH, VH, WH, UL, VL, and WL through the gate driver 112, which may provide a voltage level needed to drive gates of semiconductor power switches within power switch circuit 200 in order to control a PWM switching operation of power switch circuit 200.

Power supply regulator 114 may include one or more voltage regulators to step down power source 16 to a voltage level compatible for operating motor controller 110 and/or gate driver 112. In some implementations, power supply regulator 114 may include a buck converter and/or a linear regulator to reduce the power voltage of DC bus line 106 to, for example, 15V for powering gate driver 112 and down to, for example, 3.2V for powering motor controller 110.

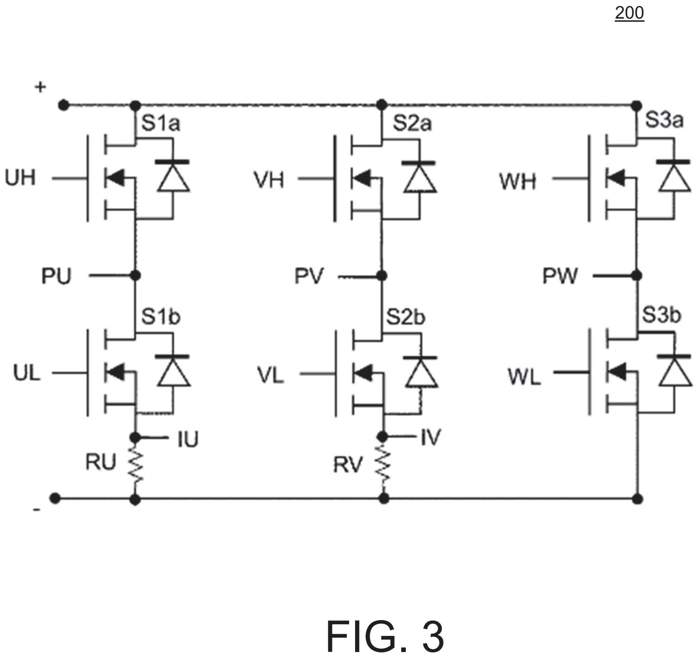

FIG. 3 depicts a circuit diagram of power switch circuit 200 of control module 100, according to some non-limiting embodiments or aspects. Power switch circuit 200 may have a three-phase inverter bridge circuit. For example, power switch circuit 200 may correspond to a three-phase motor including three sets of windings pairs, with each pair wound on two opposite stator teeth. It should be understood that the inverter bridge circuit may include more phases corresponding to the number of phases of the motor. The power switches may be, for example, MOSFETs, or FETs for short, as shown in FIG. 3, through it must be understood that IGBTs, BJTs) Gan FETs, GaN HEMTs, or similar semiconductor switches may be alternatively utilized. In this example, the three-phase inverter bridge circuit includes three high-side FETs S1a, S2a, and S3a and three low-side FETs S1b, S2b, and S3b. The gates of the high-side FETs S1a, S2a, and S3a may be driven via drive signals UH, VH, and WH, and the gates of the low-side FETs S1b, S2b, and S3b may be driven via drive signals UL, VL, and WL. In some implementations, the drains of the high-side FETs S1a, S2a, and S3a may be coupled to the sources of the low-side FETs S1b, S2b, and S3b to output power signals PU, PV, and PW for driving the electric motor 14.

However, some non-limiting embodiments or aspects of the present disclosure are not limited thereto and twelve power switches (e.g., three pairs of high-side FETs S1a, S2a, and S3a and the three pairs of low-side FETs S1b, S2b, and S3b, etc.) may be utilized for power switch circuit 200, for example, as disclosed in United States Patent Application Publication No. 2024/0072616, which is incorporated herein by reference in its entirety. Alternatively, more than the two power switches may be used for each pair of the three pairs of high-side power switches and the three pairs of low-side power switches of power switch circuit 200 for higher power applications, for example. While this disclosure makes references to FETs, it should be understood that any such power switches may be alternatively used.

The gates of the power switches may be controlled by a microcontroller in control unit 104 coupled to gate driver 112. For example, control unit 104 may construct a sinusoidal voltage waveform for each phase of the motor by controlling a Space-Vector Pulse-Width Modulated (SVPWM) of the high-side and low-side FETs in accordance with the desired Id and Iq currents, as discussed later in detail. The SVPWM technique is a modulation scheme used to determine duty cycles of the PWM signals for high-side and low-side FETs in order to apply a vector voltage as a combination of three phase voltage signals to the motor. The PWM duty cycles of the FETs are varied within each phase in a way to construct phase voltages that are substantially sinusoidal in waveform and that, when applied to the motor sequentially, cause rotation of the motor in the desired direction and speed.

Using a feedback loop of the phase currents of the motor, control unit 104 may calculate the rotor position for use in SVPWM commutation control, as described in United States Patent No 11,469,697, which is incorporated herein by reference in its entirety. In this manner, electric motor 14 may be controlled and commutated without a need for position sensors, such as Hall assembly 160, thus reducing motor size and manufacturing cost.

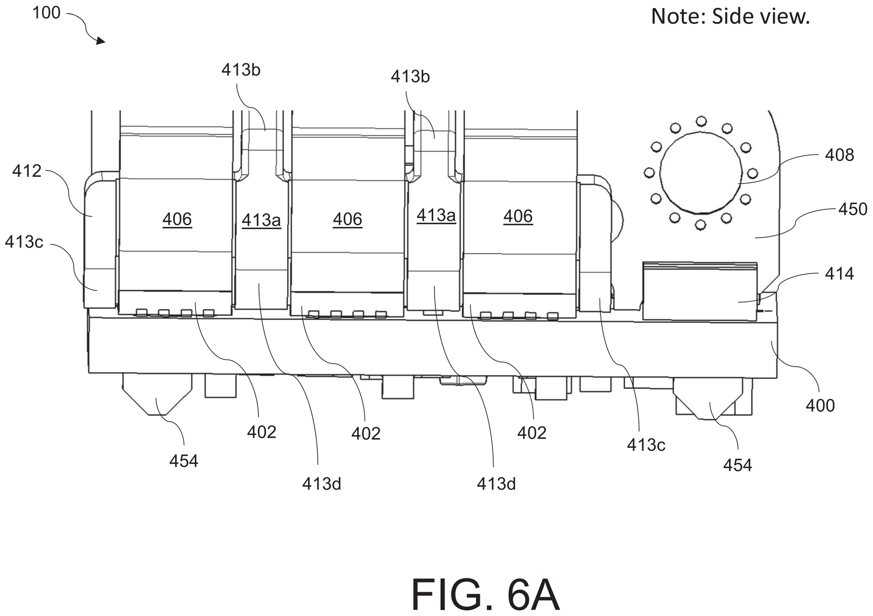

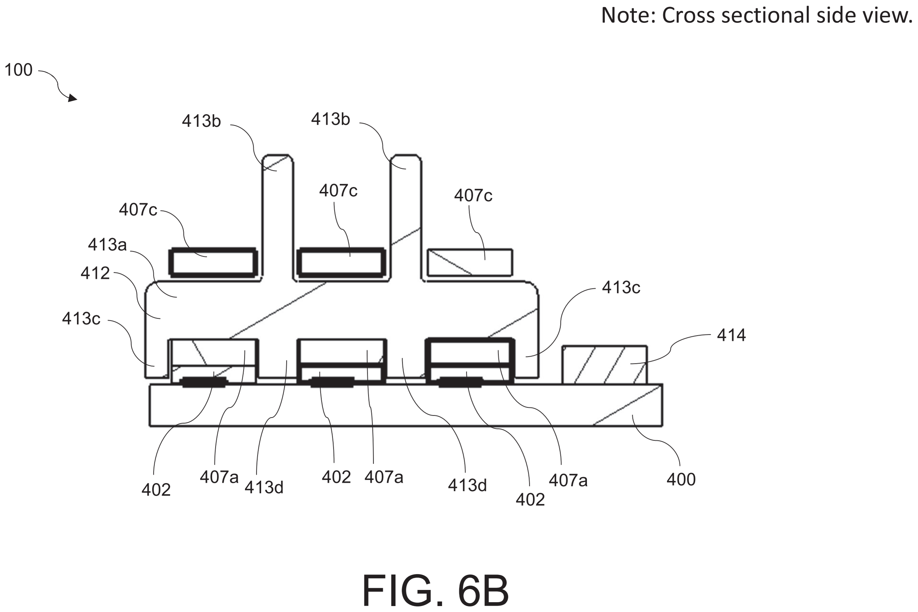

To measure the phase currents of the stator, a series of shunt resistors may be provided along the current paths of the motor phases. As shown in FIG. 3, shunt resistors RU and RV are disposed in series with the corresponding low-side FETs, between the low-side FETs S1b and S2b and the ground terminal of power source 16. By measuring the voltage across these resistors, motor controller 110 may calculate the current passing through corresponding phases of the motor. In FIG. 6, the motor phase currents are represented by signals IU and IV for simplicity, though it should be understood that motor controller 110 may measure the voltage across each shunt resistor RU and RV to calculate the phase current. For example, in FIG. 6, motor controller 110 may receive only one node of RU and RV, since the other node of RU and RV is commonly coupled to the negative terminal of power source 16.

In these embodiments, motor controller 110 may only measure two of the phase currents IU and IV and calculate the third phase current IW using Kirchhoffs current law, IU+IV+IW=0. It should be understood that motor controller 110 may alternatively receive other combinations of two signal currents (e.g., IU and IW, or IV and IW). Alternatively, motor controller 110 may receive all three current signals and rely on Kirchhoffs current law as means of redundant current measurement to ensure against circuit component failure.

In power tool applications, particularly cordless tools where size is limited, addition of the two or three shunt resistors described above to the power tool circuit presents challenges. In some implementations, instead of the three additional shunt resistors, the resistive characteristics of the FETs may be taken advantage of to measure the motor current.

In some implementations, no dedicated shunt resistors are provided, and the low-side FETs themselves may be used for current measurement. The FETs have a predominantly resistive conduction mode when in the ON-state, which can be of the order of a few milliohms or less. Thus, the resistive conduction of the low-side FETs may be leveraged in place of shunt resistors, allowing motor controller 110 to calculate the current on each motor phase. By way of example, in FIG. 6, instead of measuring current using shunt resistors RU and RV and via signals IU and IV, motor controller 110 may measure current passing through low-side FETs S1b, S2b, and S3b via signals PU, PV and PW, as described in United States Patent No. 11,469,697, which is incorporated herein by reference in its entirety.

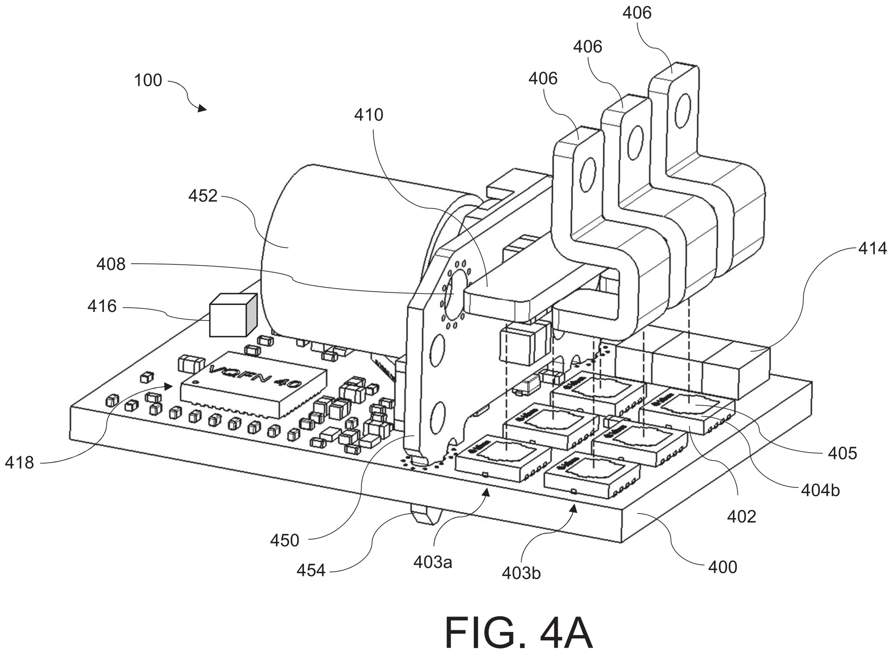

Some non-limiting embodiments or aspects of the mechanical construction of control module 100 are described herein with reference to FIGS. 4A-10B.

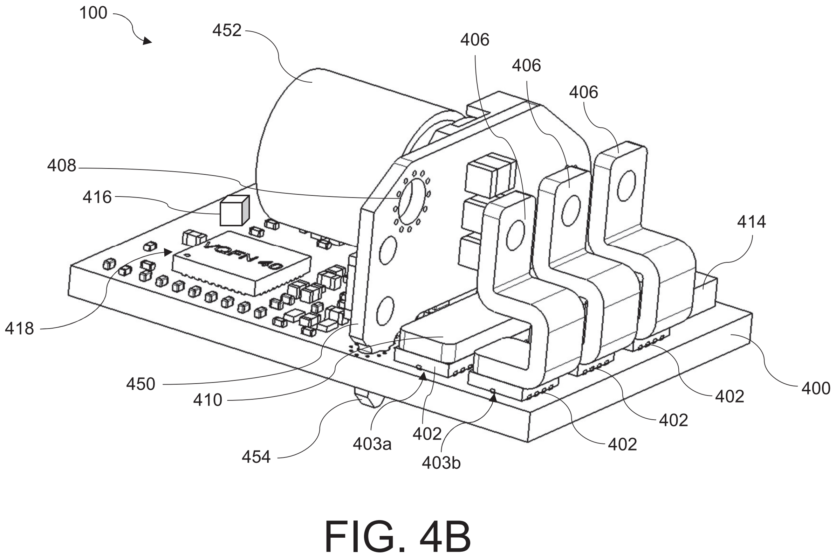

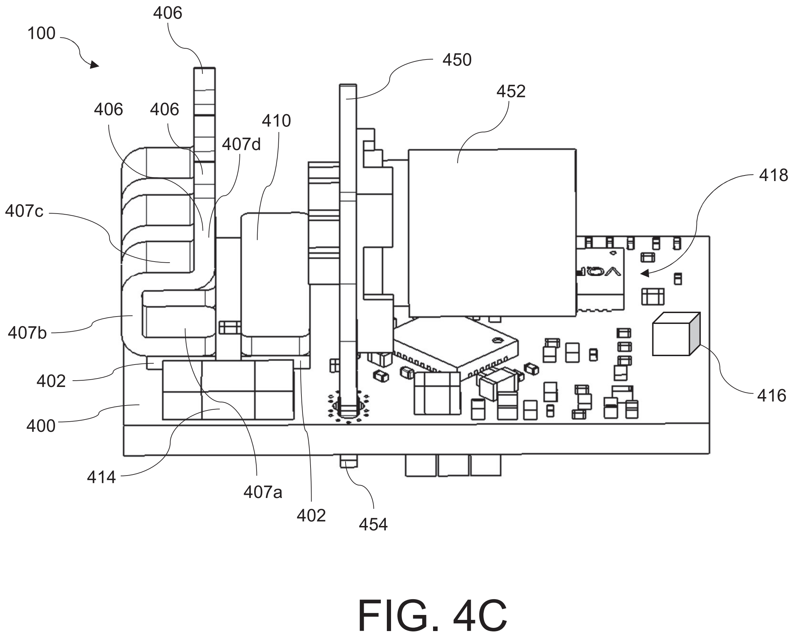

FIG. 4A depicts a partially exploded perspective view of control module 100, according to some non-limiting embodiments or aspects. FIG. 4B depicts a perspective view of control module 100, according to some non-limiting embodiments or aspects. FIG. 4C depicts a side perspective view of control module 100, according to some non-limiting embodiments or aspects. As shown in FIGS. 4A-4C, control module 100 may include circuit board 400, a plurality of power switch devices 402, and/or a plurality of power output terminals 406.

The plurality of power switch devices 402 may be configured as an inverter circuit, for example, as the three-phase inverter bridge driver circuit of power switch circuit 200 as shown in FIG. 3. For example, the plurality of power switch devices 402 may include a plurality of high-side power switches 403a and a plurality of low-side power switches 403b mounted on circuit board 400 and configured as a multi-phase inverter circuit to provide a plurality of output phase terminals to electric motor 14. As an example, the plurality of power switch devices 402 may include a first row of power switch devices including the plurality of high-side power switches 403a and a second row of power switch devices 402 mounted parallel to the first row on circuit board 400 and including the plurality of low-side power switches 403b. In such an example, the plurality of high-side power switches 403a arranged in the first row may include the three high-side FETs S1a, S2a, and S3a and the plurality of low-side power switches 403b arranged in the second row may include the three low-side FETs S1b, S2b, and S3b. Interconnections configuring the plurality of power switches 402 as a three-phase inverter circuit may be provided via metal traces on or through the circuit board 400, with DC_Bus and Gnd nodes of power switch circuit 200 electrically routed to a plurality of power input terminals 408 (e.g., to two power input terminals, etc.) and the outputs PU, PV and PW of power switch circuit 200 electrically routed to the plurality of power output terminals 406 (e.g., to three power output terminals, etc.).

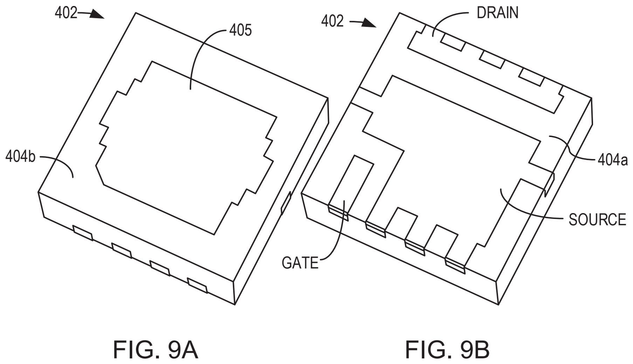

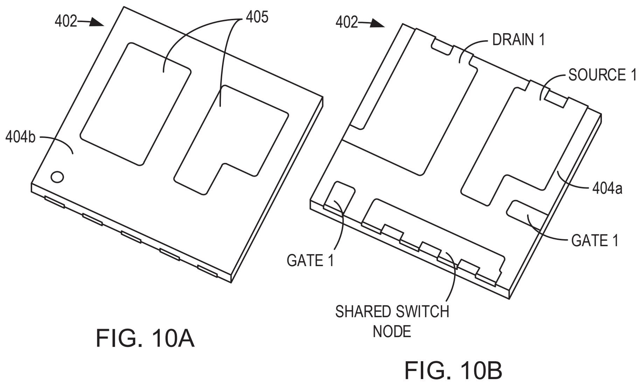

Referring also to FIGS. 9A and 9B, which are top and bottom perspective views of a power switch device 402 that includes a single power switch, and FIGS. 10A and 10B, which are top and bottom perspective view of a power switch device 402 that includes multiple power switches, each power switch device 402 may include a first surface 404a mounted on circuit board 400 and through which at least source and drain terminals of the power switch device 402 are coupled to circuit board 400, and a second surface 404b (e.g., opposite the first surface 404a) including metal surface 405 electrically coupled to the drain terminal of the power switch device 402. In some implementations, at least one power switch device of the plurality of power switch devices 402 may include a single high-side power switch or a single low-side power switch. In some implementations, at least one power switch device of the plurality of power switch devices 402 may include at least one high-side power switch of the plurality of high-side power switches 403a and at least one low-side power switch of the plurality of low-side power switches 403b connected in series in a half-bridge configuration. In some implementations, at least one power switch device of the plurality of power switch devices 402 may include at least two high-side power switches of the plurality of high-side power switches 403a connected in parallel or at least two low-side power switches of the plurality of low-side power switches 403b connected in parallel.

The plurality of power output terminals 406 may be mounted discretely on the plurality of low-side power switches and electrically contact metal surface 405 of the plurality of low-side power switches to be electrically coupled to the plurality of output phase terminals of the inverter circuit. For example, the plurality of power output terminals may not be in physical contact with circuit board 400. As an example, the plurality of power output terminals 406 may not have a direct electric contact with any node of the plurality of power switch devices 402 through the circuit board 400.

Still referring to FIGS. 4A-4C, control module 100 may further include heatsink 410 (e.g., a metal slug, etc.) having an elongate body extending along an axis mounted on the second surface 404b of the plurality of high-side power switches 403a. Heatsink 410 may be electrically coupled to metal surface 405 of the plurality of high-side power switches 403a. Alternatively, heatsink 410 may include a plurality of heatsinks (e.g., a plurality of metal slugs, etc.) discretely mounted on the second surfaces 404b of the plurality of high-side power switches 403a. For example, the plurality of heatsinks 410 may be discretely electrically coupled to metal surfaces 405 of the plurality of high-side power switches 403a.

The plurality of power output terminals 406 may extend from metal surfaces 405 of the plurality of power switch devices 402 including the low-side power switches 403b along a plane that is perpendicular to circuit board 400. For example, the plane may intersect the plurality of low-side power switches 403b. In some implementations, the axis of the elongate body of heatsink 410 may be parallel to the plane. The plurality of power output terminals 406 may include a first power output terminal or post, a second power output terminal or post, and a third power output terminal or post (e.g., three power output terminals 406, etc.). The three power output terminals 406 may be arranged in a row with the second power output terminal or post between the first power output terminal or post and the third power output terminal or post. The three power output terminals 406 may be mounted near a front edge of circuit board 400 on metal surface 405 of the plurality of power switch devices 402 including the low-side power switches 403b for coupling to the phases PU, PV, PW of electric motor 14.

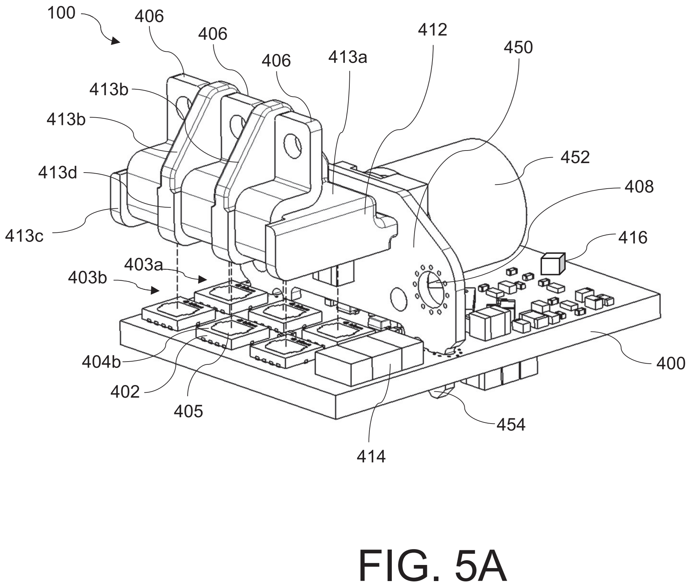

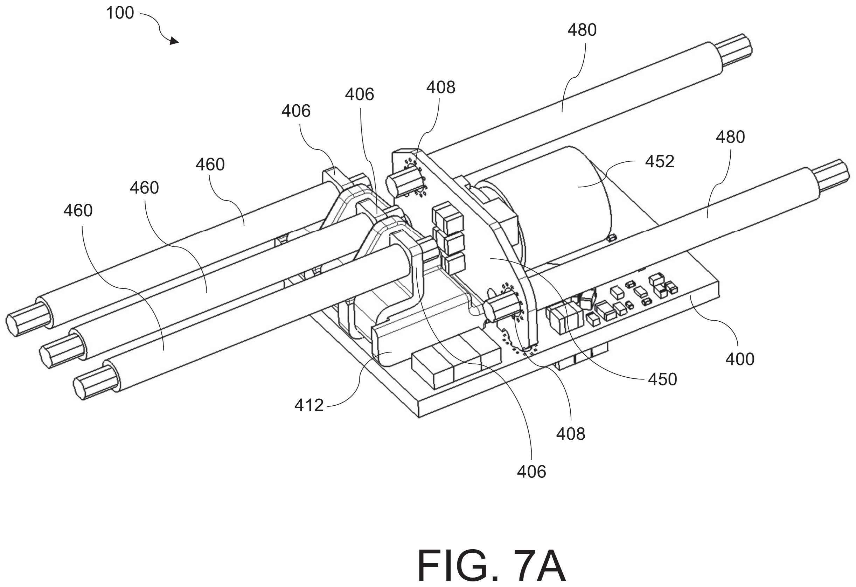

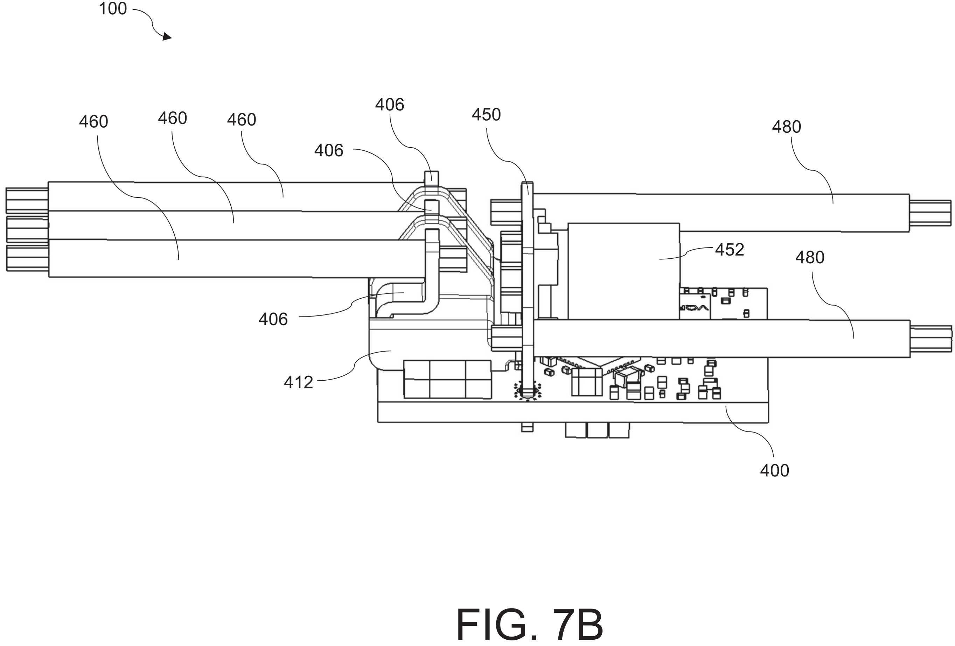

Still referring to FIGS. 4A-4C, and referring also to FIG. 7A, which depicts a perspective view of control module 100 with power output wires 460 and power input wires 480 respectively connected to power output terminals 406 and power input terminals 408 of control module 100, according to some non-limiting embodiments or aspects, and FIG. 7B, which depicts a side perspective view of control module 100 with power output wires 460 and power input wires 480 respectively connected to power output terminals 406 and power input terminals 408 of control module 100, according to some non-limiting embodiments or aspects, as shown in FIGS. 4A-5C, 7A, and 7B, the plurality of power output terminals 406 may extend from a plurality of first ends mounted discretely on the plurality of low-side power switches 403b and electrically contacting metal surface 405 of the plurality of low-side power switches 403b to a plurality of second ends including a plurality of power output holes configured to receive the plurality of power output wires 460. For example, the plurality of power output terminals 406 may include a plurality of first portions 407a including the plurality of first ends mounted discretely on the plurality of low-side power switches 403b and electrically contacting metal surface 405 of the plurality of low-side power switches 403b (e.g., sandwiched between the plurality of low-side power switches 403b and base portion 413a of insulating frame 412 as shown in FIGS. 5A-5C), a plurality of second portions 407b extending perpendicularly from the plurality of first portions 407a (e.g., along an end of base portion 413a of insulating frame 412 adjacent the front edge of circuit board 400 and in upright direction relative to circuit board 400 as shown in FIGS. 5A-5C), a plurality of third portions 407c extending perpendicularly from the plurality of second portions 407b (e.g., extending over the plurality of low-side power switches 403b and base portion 413a of insulating frame 412 as shown in FIGS. 5A-5C, extending parallel to circuit board 400, etc.), and a plurality of fourth portions 407d including the plurality of second ends including the plurality of power output holes extending perpendicularly from the plurality of third portions 407c (e.g., extending in an upright direction relative to circuit board 400, etc.). the plurality of power output holes at the plurality of second ends of the plurality of power output terminals 406 may be configured to receive ends of the plurality of power output wires 460 (e.g., ends of motor phase wires, etc.).

The plurality of power output wires 460 may be soldered to the plurality of power output terminals 406 at the plurality of power output holes at the plurality of second ends of the plurality of power output terminals 406. The plurality of second ends of the plurality of power output terminals 406 including the plurality of power output holes may be oriented substantially perpendicular to circuit board 400. For example, the plurality of power output wires 460 may extend from the plurality of power output terminals 406 substantially parallel to circuit board 400.

The plurality of power input terminals 408 may include a plurality of metallic plated holes in auxiliary circuit board 450, which may extend substantially perpendicular to circuit board 400. For example, the plurality of power input wires 480 may be soldered to the plurality of power input terminals 408 at the plurality of metallic plated holes in auxiliary circuit board 450. As an example, the plurality of power input wires 480 may extend from the plurality of power input terminals 408 in a substantially parallel to circuit board 400.

In some implementations, control module 100 may further an auxiliary circuit board 450 that extends substantially perpendicularly from circuit board 400. Auxiliary circuit board 450 may include the plurality of power input terminals 408 as a pair of metallic plated holes configured to receive a corresponding pair of power input wires 480 electrically coupled to corresponding nodes of power source 16. Auxiliary circuit board 450 may include at least one capacitor 452 mounted on auxiliary circuit board 450 and extending substantially parallel to circuit board 400. Auxiliary circuit board 450 may include one or more legs 454 received through corresponding slots in circuit board 400 to supports its upright orientation. In some implementations, the one or more legs 454 may be soldered to circuit board 400. The arrangement of the at least one capacitor 452 mounted on auxiliary circuit board 450 and extending substantially parallel to circuit board 400 may significantly reduce a length and a height of control module 100. The height of control module 100 may be reduced because the at least one capacitor 452 may have a greater height than diameter, thus the at least one capacitor 452 may add significantly less height to control module in this orientation than it would in a conventional upright orientation. Further, the length of control module 100 may be reduced because the at least one capacitor 452 may overlay other circuitry and electronic components mounted on circuit board 400, thus making no significant contribution to the overall length of control module 100.

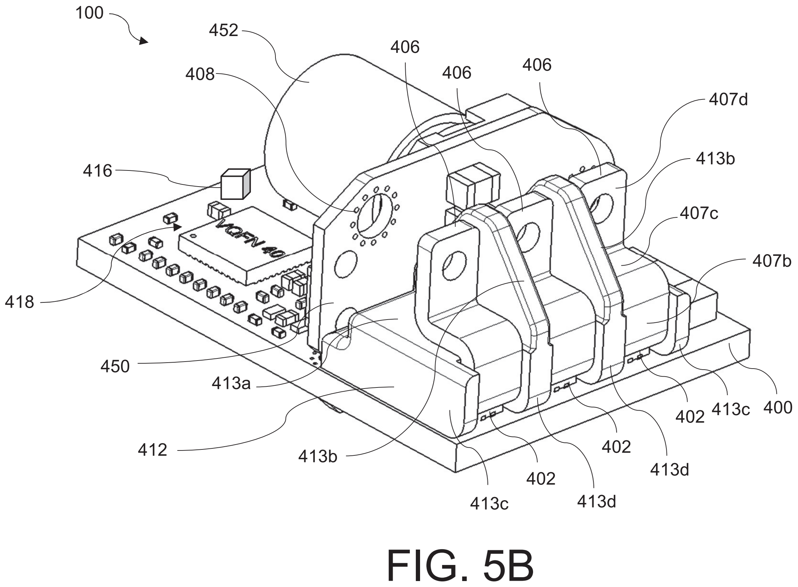

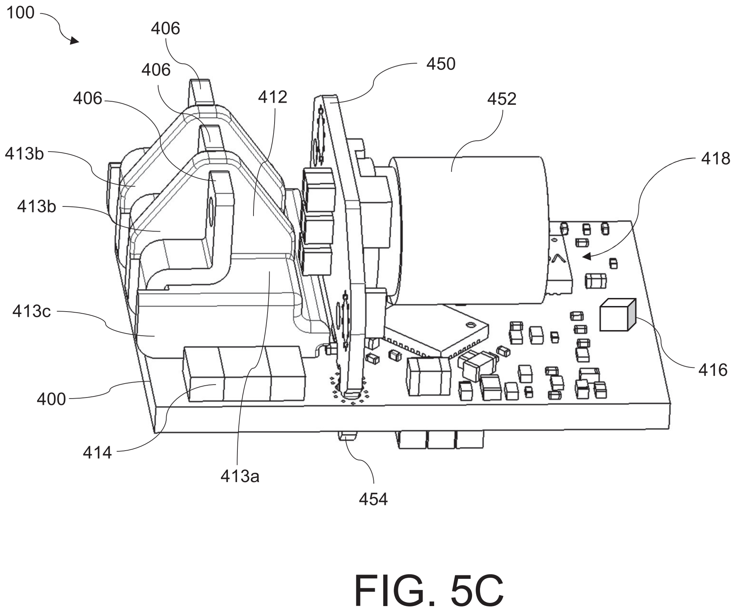

FIG. 5A depicts a partially exploded perspective view of control module 100 including insulating frame 412, according to some non-limiting embodiments or aspects. FIG. 5B depicts a perspective view of control module 100 including insulating frame 412, according to some non-limiting embodiments or aspects. FIG. 5C depicts a side perspective view of control module 100 including insulating frame 412, according to some non-limiting embodiments or aspects. As shown in FIGS. 5A-5C, control module 100 may include insulating frame 412. Insulating frame 412 may be configured to physically and structurally support the plurality of power output terminals 406 in upright positions and in contact with the second (top) surfaces 404b of the plurality of low-side power switches 403b.

Insulating frame 412 may include base portion 413a that extends between the plurality of first portions 407a of the plurality of power output terminals 406 and the plurality of third portions 407c of the plurality of power output terminals 406. For example, base portion 413a may cover the first portions 407a of the plurality of power output terminals 406 and hold or press the first portions 407a of the plurality of power output terminals 406 against the second (top) surfaces 404b of the plurality of low-side power switches 403b. As an example, the first portion 407a of each power output terminal of the plurality of power output terminals 406 may be sandwiched between base portion 413a and the second (top) surfaces 404b of a low-side power switch of the plurality of low-side power switches 403b. In some implementations, base portion 413a may cover at least a top surface of heatsink 410 and hold or press heatsink 410 against the second (top) surfaces 404b of the plurality of high-side power switches 403a. Alternatively, base portion 413a may be spaced apart from the top surface of heatsink 410 to provide for improved air flow over heatsink 410 or base portion 413a may not cover the top surface of heatsink 410.

Insulating frame 412 may include at least one upper partition wall 413b extending from base portion 413a in a direction away from or perpendicular to circuit board 400 and base portion 413a between at least one pair of power output terminals of the plurality of power output terminals 406. For example, a first upper partition wall 413b may extend between a first power output terminal and a second power output terminal and a second upper partition wall 413b may extend between the second power output terminal and a third power output terminal. The at least one upper partition wall 413b may extend in the direction away from or perpendicular to circuit board 400 and base portion 413a a same distance, a greater distance, or a shorter distance than the plurality of power output terminals 406 when insulating frame 412 is mounted or molded on the plurality of power output terminals 406. In this way, insulating frame 412 may inhibit or prevent metal particles and/or post breakage from electrically connecting adjacent power output terminals of the plurality of power output terminals 406. For example, a taller at least one upper partition wall 413b of insulating frame 412 may provide better protection against electrical connection of adjacent power output posts, and a shorter at least one upper partition wall 413b of insulating frame 412 may provide easier access to the plurality of power output terminals 406. Moreover, the additional mechanical retention, to vibration or other mechanical forces, thermal cycling etc. that the insulating frame 412 provides to the plurality of power output terminals 406 can inhibit or prevent sheering or breakage of the exposed metallic terminals from internal connections of the plurality of power switch device 402 because the metal surface 405 or exposed metallic terminal of the plurality of power switch devices 402 is electrically and mechanically connected to an internal die of the power switch device. This bond connects the silicon die of a power switch (e.g., a MOSFET, etc.) to the package of the device, thus providing a channel for current to flow into and/or out of the device. Historically this bond was made of many small gauge wires in parallel, but more recently has been constructed of a copper clip, which enhances thermal performance, reduces thermal and electrical resistance, reduces package inductance and increases current conductivity capabilities.

Insulating frame 412 may include at least one sidewall 413c extending from at least one end of base portion 413a toward circuit board 400. For example, the at least one sidewall 413c may be mounted on circuit board 400 or come in close contact with circuit board 400. As an example, the at least one sidewall 413c may include a locking or retention feature that engages circuit board 400 to secure insulating frame 412 to circuit board 400. Alternatively, or additionally, insulating frame 412 may be secured relative to circuit board 400 via a layer of potting (e.g., resin, etc.) material (not shown) that substantially covers circuit board 400 and insulating frame 412.

Insulating frame 412 may include at least one lower partition wall 413d extending from base portion 413a in a direction toward circuit board 400 between at least one pair of low-side power switches of the plurality of low-side power switches 403b. For example, the at least one lower partition wall 413d may be sized to be fitted within a gap between adjacent power switches of the plurality of low side power switches 403b (see Fig. 6B).

Insulating frame 412 may be molded on the plurality of power output terminals 406 via an overmolding or insert-molding process. Alternatively, insulating frame 412 may be a discrete insulating (e.g., plastic, etc.) component shaped to interface with the power output terminals 406 and circuit board 400.

At least one shunt component 414 (e.g., at least one of shunt resistor RU, shunt resistor RV, shunt resistor RW, or any combination thereof, etc.) may be mounted on circuit board 400 and electrically coupled in series with at least one low-side power switch of the plurality of low-side power switches 403b and a node of power source 16. For example, at least one shunt component 414 may be electrically coupled to at least one of the low-side FETs S1b, S2b, and S3b. The at least one shunt component 414 (e.g., a plurality of shunt components 414, etc.) may be arranged in a third row on circuit board 400 arranged perpendicular to and at an end of each of the first row of power switch devices including the plurality of high-side power switches 403a and the second row of power switch devices 402 parallel to the first row and including the plurality of low-side power switches 403b.

One or more connectors 416 (e.g., ribbon connectors, USB connectors, sealed connectors, non-sealed connectors, etc.) configured to provide at least one of a digital signal, an analog signal, or any combination thereof, may mounted on circuit board 400. For example, the one or more connectors 416 may be mounted near a rear edge of circuit board 400 that is parallel to the front edge of circuit board 400. The one or more connectors 416 may provide various digital and/or analog signal wires, including but not limited to temperature signals, Hall signals, speed signals, switch signals, user interface signals etc. to motor controller 110.

Components 418 of control unit 104 (FIG. 2), including motor controller 110 (e.g., a microcontroller, etc.), gate driver 112, and/or power supply regulator 114, may be mounted on circuit board 400. For example, components 418 of control unit 104 may be mounted between auxiliary circuit board 450 and the one or more connectors 416. In this way, many components 418 of control unit 104 (FIG. 2), including motor controller 110, gate driver 112, and power supply regulator 114, may be mounted on the top surface of circuit board 400 and overlaid by the at least one capacitor 452. In some implementations, the at least one capacitor 452 may form bus capacitor 108 (FIG. 2). The at least one capacitor 452 may be electrically connected via conductive traces that pass along (or through) the one or more legs 454 and the soldering connections to circuit board 400.

In some implementations, motor controller 110 may be configured to monitor a current passing through the at least one shunt component 414; and control, based on the current passing through the at least one shunt component 414, a field-oriented communication of electric motor 14 powered by control module 100.

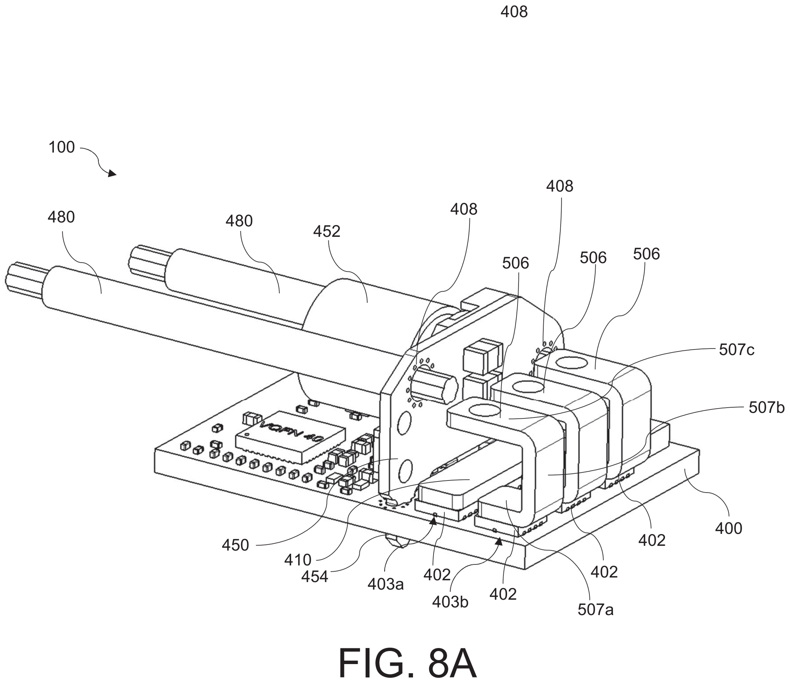

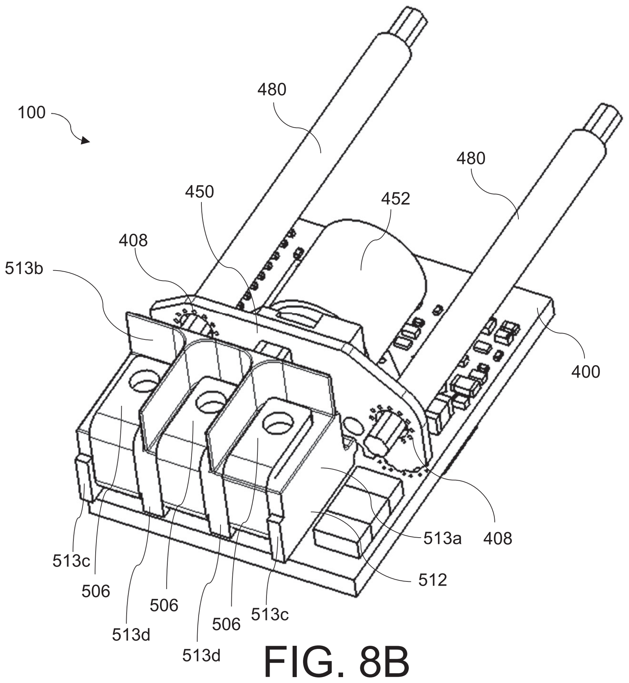

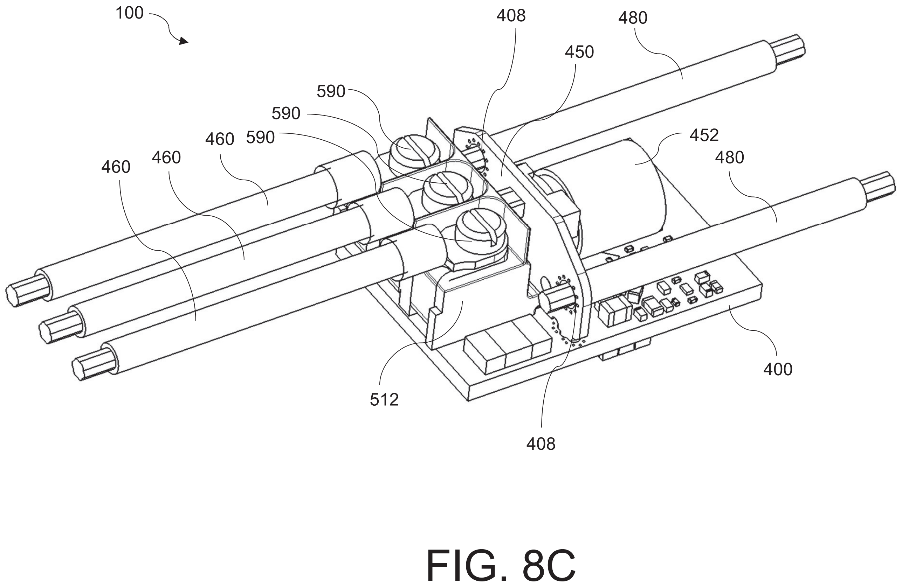

FIG. 8A depicts a perspective view of control module 100 with power output terminals 506 configured for ring terminal connections, according to some non-limiting embodiments or aspects. FIG. 8B depicts a top perspective view of control module 100 with power output terminals 506 configured for ring terminal connections, according to some non-limiting embodiments or aspects. FIG. 8C depicts a perspective view of control module 100 with power output terminals 506 with ring terminal connections connecting power output wires 460 to the power output terminals 406, according to some non-limiting embodiments or aspects. As shown in FIGS. 8A-8C, the plurality of power output terminals 506 may extend from a plurality of first ends mounted discretely on the plurality of low-side power switches 403b and electrically contacting metal surface 405 of the plurality of low-side power switches 403b to a plurality of second ends including a plurality of power output holes configured to receive a plurality of fasteners 590 electrically coupled to a plurality of ring terminals electrically coupled to the plurality of power output wires 460. For example, the plurality of power output terminals 506 may include a plurality of first portions 507a including the plurality of first ends mounted discretely on the plurality of low-side power switches 403b and electrically contacting metal surface 405 of the plurality of low-side power switches 403b, a plurality of second portions 507b extending perpendicularly from the plurality of first portions 507a, and a plurality of third portions 507c including the plurality of second ends including the plurality of power output holes extending perpendicularly from the plurality of second portions 507 over the plurality of first portions 507a including the plurality of first ends mounted discretely on the plurality of low-side power switches 403b (and over base portion 513a of insulating frame 512). As an example, a plurality of third portions 507c including the plurality of second ends including the plurality of power output holes may extend parallel to circuit board 400, base portion 513a of insulating frame 512, and the plurality of first portions 507a.

As further shown in FIGS. 8A-8b, control module 100 may include insulating frame 512. Insulating frame 512 may be configured to physically and structurally support the plurality of power output terminals 506 in upright positions and in contact with the second (top) surfaces 404b of the plurality of low-side power switches 403b. Insulating frame 512 may be configured to form a support base for the plurality of fasteners 590 and/or the plurality of ring terminals electrically coupled to the plurality of power output wires 460.

Insulating frame 512 may include base portion 513a extending between the plurality of first portions 507a of the plurality of power output terminals 506 and the plurality of third portions 507c of the plurality of power output terminals 506. For example, base portion 513a may cover the first portions 507a of the plurality of power output terminals 506 and hold or press the first portions 507a of the plurality of power output terminals 506 against the second (top) surfaces 404b of the plurality of low-side power switches 403b. As an example, the first portion 507a of each power output terminal of the plurality of power output terminals 506 may be sandwiched between base portion 513a and the second (top) surfaces 504b of a low-side power switch of the plurality of low-side power switches 403b. In some implementations, base portion 513a may cover at least a portion of a top surface of heatsink 410 and hold or press heatsink 410 against the second (top) surfaces 404b of the plurality of high-side power switches 403a. Alternatively, base portion 513a may be spaced apart from the top surface of heatsink 410 to provide for improved air flow over heatsink 410, or base portion 513a may not cover heatsink 410.

Insulating frame 512 may include at least one upper partition wall 513b extending from base portion 513a in a direction away from and/or perpendicular to circuit board 400 between at least one pair of power output terminals of the plurality of power output terminals 506 and proximate the second end of at least on power output terminal of the at least one pair of power output terminals. For example, the at least one upper partition wall 513b may extend between the second end of the at least on power output terminal of the at least one pair of power output terminals and auxiliary circuit board 450. As an example, the at least one upper partition wall 513b may surround two or more sides of the at least on power output terminal of the at least one pair of power output terminals. In such an example, the at least one upper partition wall 513b may not surround the at least one power output terminal at a side of the at least one power output terminal adjacent to or facing the front edge of circuit board 400 to enable access to the at least one power output terminal (e.g., for connecting a motor phase wire thereto, etc.). The at least one upper partition wall 513b may extend in the direction away from and/or perpendicular to circuit board 400 a greater distance than the plurality of power output terminals 506 when insulating frame 512 is mounted or molded on the plurality of power output terminals 506. For example, the at least one upper partition wall 513b may extend in the direction away from and/or perpendicular to circuit board 400 a same or greater distance than a height of the plurality of fasteners 590 electrically coupled to the plurality of ring terminals above the plurality of power output terminals 506. In this way, insulating frame 512 may inhibit or prevent metal particles and/or post breakage from electrically connecting adjacent power output terminals or ring terminals.

Insulating frame 512 may include at least one sidewall 513c extending from at least one end of base portion 513a toward circuit board 400. For example, the at least one sidewall 513c may be mounted on circuit board 400 or come in close contact with circuit board 400. As an example, the at least one sidewall 513c may include a locking or retention feature that engages circuit board 400 to secure insulating frame 512 to circuit board 400. Alternatively, or additionally, insulating frame 512 may be secured relative to circuit board 400 via a layer of potting (e.g., resin, etc.) material (not shown) that substantially covers circuit board 400 and insulating frame 512.

Insulating frame 512 may include at least one lower partition wall 513d extending from base portion 513a in a direction toward circuit board 400 between at least one pair of low-side power switches of the plurality of low-side power switches 403b. For example, the at least one lower partition wall 513d may be sized to be fitted within a gap between adjacent power switches of the plurality of low-side power switches 403b.

The plurality of power output wires 460 may be mechanically and electrically connected to the plurality of power output terminals 506 at the plurality of power output holes at the plurality of second ends of the plurality of power output terminals 506 via the plurality of fasteners 590 and the plurality of ring terminals. The plurality of second ends of the plurality of power output terminals 506 including the plurality of power output holes may be oriented substantially perpendicular to circuit board 400. For example, the plurality of power output wires 460 may extend from the plurality of power output terminals 506 substantially parallel to circuit board 400.

Referring now to FIGS. 4A-5C and 7A-10B, and referring particularly to FIGS. 6A and 6B, which depict a side view and a cross sectional view of control module 100, according to some non-limiting embodiments or aspects, in some implementations, the second surfaces 404b including metal surfaces 405 of the plurality of power switch devices 402 may be oriented along a first plane, first portions 407a or 507a of the plurality of power output terminals 406 or 506 that electrically contact metal surfaces 405 of the plurality of power switch devices 402 may be oriented along a second plane parallel to the first plane, and each power output terminal 406 or 506 may located substantially above a corresponding power switch device 402. For example, each power output terminal 406 or 506 may be oriented along a plane that is perpendicular to the second plane.

In some implementations, circuit board 400 may be oriented along a first plane, first portions 407a or 507a of the plurality of the plurality of power output terminals 406 or 506 that electrically contact metal surfaces 405 of the plurality of power switch devices 402 may be oriented along a second plane, and each power output terminal 406 or 506 may be located substantially above a corresponding power switch device. For example, each power output terminal 406 may be oriented along a plane that is perpendicular to the first plane. Second surfaces 404b including metal surfaces 405 of the plurality of power switch devices 402 may be oriented along a third plane parallel to the first plane and the second plane. For example, the second surfaces 404b including metal surfaces 405 of the plurality of power switch devices 402 may be oriented between the first plane and the second plane.

In some implementations, the plurality of power switch devices 402 may define a boundary area on the circuit board 400 that includes the plurality of power switch devices 402 and a spacing between the plurality of power switch devices 402, control module 100 may be configured to sustain a continuous current output of approximately 14 to 30 A, preferably approximately 17A to 25A, at a nominal voltage level of approximately between 8V-20V, preferably approximately between 17-19V, and the plurality of power output terminals 406 or 506 may be contained within the boundary area. A first cumulative area within the boundary area that is defined by the plurality of power switch devices 402 themselves may be greater than a second cumulative area within the boundary area that is defined by the spacing between the plurality of power switch devices 402, wherein the first cumulative area may include at least 76% of the boundary area, preferably at least approximately 80% of the boundary area, more preferably at least approximately 84% of the boundary area, and even more preferably at least approximately 88% of the boundary area, and/or the second cumulative area may be between approximately 12% to 24% of the boundary area.

In some implementations, an area of circuit board 400 proximate the plurality of power switch devices 402 may not include through holes configured to secure the plurality of power output terminals 406 or 506 to circuit board 400. For example, circuit board 400 may be free of through holes configured to secure the plurality of power output terminals 406 or 506 to the circuit board 400.

In some implementations, a greater portion of a static strength of a connection of the plurality of power output terminals 406 or 506 to circuit board 400 may be provided via first portions 407a or 507a of the plurality of power output terminals 406 or 506 mounted discretely on the plurality of low-side power switches 403b than remaining portions of the plurality of power output terminals 406 or 506 not mounted discretely on the plurality of low-side power switches 403b.

Although embodiments have been described in detail for the purpose of illustration, it is to be understood that such detail is solely for that purpose and that the disclosure is not limited to the disclosed embodiments or aspects, but, on the contrary, is intended to cover modifications and equivalent arrangements that are within the spirit and scope of the appended claims. For example, it is to be understood that the present disclosure contemplates that, to the extent possible, one or more features of any embodiment or aspect can be combined with one or more features of any other embodiment or aspect.

## Claims

1. A control module for supplying electric power from a DC power source to an electric motor, comprising:
a circuit board;
a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and
a plurality of power output terminals mounted discretely on the plurality of low-side power switches and electrically contacting the metal surface of the plurality of low-side power switches to be electrically coupled to the plurality of output phase terminals of the inverter circuit,
wherein the second surfaces including the metal surfaces of the plurality of power switch devices are oriented along a first plane, wherein lower portions of the plurality of power output terminals that electrically contact the metal surfaces of the plurality of power switch devices are oriented along a second plane parallel to the first plane, and wherein at least one of (i) each power output terminal is located substantially above a corresponding power switch, (ii) each power output terminal is oriented along a plane that is perpendicular to the second plane, or any combination thereof.

2. A control module for supplying electric power from a DC power source to an electric motor, comprising:
a circuit board;
a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and
a plurality of power output terminals mounted discretely on the plurality of low-side power switches and electrically contacting the metal surface of the plurality of low-side power switches to be electrically coupled to the plurality of output phase terminals of the inverter circuit,
wherein the circuit board is oriented along a first plane, wherein lower portions of the plurality of the plurality of power output terminals that electrically contact the metal surfaces of the plurality of power switch devices are oriented along a second plane, wherein at least one of (i) each power output terminal is located substantially above a corresponding power switch, (ii) each power output terminal is oriented along a plane that is perpendicular to the first plane, or any combination thereof, and wherein the second surfaces including the metal surfaces of the plurality of power switch devices are oriented along a third plane parallel to the first plane and the second plane.

3. A control module for supplying electric power from a DC power source to an electric motor, comprising:
a circuit board;
a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and
a plurality of power output terminals mounted discretely on the plurality of low-side power switches and electrically contacting the metal surface of the plurality of low-side power switches to be electrically coupled to the plurality of output phase terminals of the inverter circuit,
wherein the circuit board is oriented along a first plane, wherein lower portions of the plurality of the plurality of power output terminals that electrically contact the metal surfaces of the plurality of power switch devices are oriented along a second plane, wherein at least one of (i) each power output terminal is located substantially above a corresponding power switch, (ii) each power output terminal is oriented along a plane that is perpendicular to the first plane, or any combination thereof, and wherein the second surfaces including the metal surfaces of the plurality of power switch devices are oriented between the first plane and the second plane.

4. A control module for supplying electric power from a DC power source to an electric motor, comprising:
a circuit board;
a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and
a plurality of power output terminals mounted discretely on the plurality of low-side power switches and electrically contacting the metal surface of the plurality of low-side power switches to be electrically coupled to the plurality of output phase terminals of the inverter circuit,
wherein the plurality of power switch devices defines a boundary area on the circuit board that includes the plurality of power switch devices and a spacing between the plurality of power switch devices, wherein the control module is configured to sustain a continuous current output of approximately 14 to 30 amps at a nominal voltage level of approximately between 8 to 20 volts, wherein the plurality of power output terminals is contained within the boundary area,
wherein a first cumulative area within the boundary area that is defined by the plurality of power switch devices themselves is greater than a second cumulative area within the boundary area that is defined by the spacing between the plurality of power switch devices, and
wherein the first cumulative area includes at least 76% of the boundary area.

5. A control module for supplying electric power from a DC power source to an electric motor, comprising:
a circuit board;
a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and
a plurality of power output terminals mounted discretely on the plurality of low-side power switches and electrically contacting the metal surface of the plurality of low-side power switches to be electrically coupled to the plurality of output phase terminals of the inverter circuit,
wherein the plurality of power switch devices defines a boundary area on the circuit board that includes the plurality of power switch devices and a spacing between the plurality of power switch devices, wherein the control module is configured to sustain a continuous current output of approximately 14 to 30 amps at a nominal voltage level of approximately between 8 to 20 volts, wherein the plurality of power output terminals is contained within the boundary area, and
wherein a first cumulative area within the boundary area that is defined by the plurality of power switch devices themselves is greater than a second cumulative area within the boundary area that is defined by the spacing between the plurality of power switch devices, and
wherein the second cumulative area is between approximately 12% to 24% of the boundary area.

6. A control module for supplying electric power from a DC power source to an electric motor, comprising:
a circuit board;
a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and
a plurality of power output terminals mounted discretely on the plurality of low-side power switches and electrically contacting the metal surface of the plurality of low-side power switches to be electrically coupled to the plurality of output phase terminals of the inverter circuit,
wherein the circuit board is free of through holes configured to secure the plurality of power output terminals to the circuit board.

7. A control module for supplying electric power from a DC power source to an electric motor, comprising:
a circuit board;
a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and
a plurality of power output terminals mounted discretely on the plurality of low-side power switches and electrically contacting the metal surface of the plurality of low-side power switches to be electrically coupled to the plurality of output phase terminals of the inverter circuit,
wherein an area of the circuit board proximate the plurality of power switches does not include through holes configured to secure the plurality of power output terminals to the circuit board.

8. A control module for supplying electric power from a DC power source to an electric motor, comprising:
a circuit board;
a plurality of power switch devices including a plurality of high-side power switches and a plurality of low-side power switches mounted on the circuit board and configured as a multi-phase inverter circuit to provide a plurality of output phase terminals to the electric motor, wherein each power switch device includes a first surface mounted on the circuit board and through which at least source and drain terminals of the power switch device are coupled to the circuit board, and a second surface including a metal surface electrically coupled to the drain terminal of the power switch device; and
a plurality of power output terminals mounted discretely on the plurality of low-side power switches and electrically contacting the metal surface of the plurality of low-side power switches to be electrically coupled to the plurality of output phase terminals of the inverter circuit,
wherein a greater portion of a static strength of a connection of the plurality of power output terminals to the circuit board is provided via first portions of the plurality of power output terminals mounted discretely on the plurality of low-side power switches than remaining portions of the plurality of power output terminals not mounted discretely on the plurality of low-side power switches.

9. The control module of any of claims 1-8, further comprising:
a heatsink having an elongate body extending along an axis mounted on the second surface of the plurality of high-side power switches, wherein the heatsink is electrically coupled to the metal surface of the plurality of high-side power switches.

10. The control module of any of claims 1-9, wherein the plurality of power output terminals is not in physical contact with the circuit board.

11. The control module of any of claims 1-10, wherein the plurality of power output terminals does not have a direct electric contact with any node of the plurality of power switch devices through the circuit board.

12. The control module of any of claims 1-11, wherein the plurality of power output terminals extends from the metal surfaces of the plurality of power switch devices including the low-side power switches along a plane that is perpendicular to the circuit board.

13. The control module of claim 12, wherein the plane intersects the plurality of low-side power switches.

14. The control module of claim 12 or 13, further comprising:
a heatsink having an elongate body extending along an axis mounted on the second surface of the plurality of high-side power switches,
wherein the axis of the elongate body of the heatsink is parallel to the plane.

15. The control module of any of claims 1-14, wherein at least one power switch device of the plurality of power switch devices includes at least one high-side power switch of the plurality of high-side power switches and at least one low-side power switch of the plurality of low-side power switches connected in series in a half-bridge configuration.
